# EUROPEAN PATENT APPLICATION

(11) **EP 4 641 620 A1**
(43) Date of publication of application: **29.10.2025**
(21) Application number: 23906483.5
(22) Date of filing: 01.11.2023
(51) Int. Cl.: H01L 21/304, B08B 3/02, B24B 21/00, B24B 55/06, H01L 21/683

(54) **SUBSTRATE PROCESSING APPARATUS AND SUBSTRATE PROCESSING METHOD**

(30) Priority: 23.12.2022 JP 2022206273
(71) Applicant: EBARA CORPORATION, Ota-ku, Tokyo 144-8510 (JP)
(72) Inventor: YAMAMOTO, Satoru, Tokyo 144-8510 (JP); UCHIYAMA, Keisuke, Tokyo 144-8510 (JP); YAMANOBE, Hokuto, Tokyo 144-8510 (JP)
(74) Representative: Carstens, Dirk Wilhelm
(86) International application number: PCT/JP2023/039425
(87) International publication number: WO 2024/135111

(57) **Abstract**

The present invention relates to a substrate processing apparatus and a substrate processing method for cleaning a substrate after polishing. The substrate cleaning apparatus includes a cleaning apparatus (131) for cleaning a polished substrate. The cleaning apparatus (131) includes a microbubble-water module (90) for injecting microbubble water onto the surface of the substrate (W), held in a substrate cleaning holder (52), to clean a surface of the substrate (W). The microbubble-water module (90) includes an injection nozzle (91) for injecting the microbubble water onto a target region (TR), which is an elongated region extending from a center (Cr) to an outer peripheral portion (Ci) of the substrate (W), and a microbubble-water supply device (93) for supplying the microbubble water to the injection nozzle (91).

## Description

### Technical Field

The present invention relates to a substrate processing apparatus and a substrate processing method for cleaning a substrate (e.g., semiconductor wafer) after polishing, and in particular, relates to a substrate processing apparatus and a substrate processing method for cleaning a surface of a substrate after polishing a peripheral portion of the substrate.

### Background Art

Management of a surface condition of a substrate, such as a wafer, has recently attracted attention from the viewpoint of an increase in a yield in manufacturing of semiconductor devices. In a semiconductor device manufacturing process, films of various materials are formed on a silicon wafer. Therefore, an unnecessary film or surface roughness may be formed on a peripheral portion of the substrate. These days it is a common practice to transfer a substrate by holding only a peripheral portion of the substrate with arms. With such a background, an unnecessary film, remaining on the peripheral portion of the substrate, may peel off during various processes and may adhere to devices formed on the substrate, resulting in reduced a yield.

Thus, from the viewpoint of an increase in a yield in manufacturing of semiconductor devices, the peripheral portion of the substrate is polished in order to remove the unnecessary film from the peripheral portion of the substrate. When polishing the peripheral portion of the substrate, foreign matters (particles), such as polishing debris, may adhere to the substrate. If foreign matters (particles), such as polishing debris, adhere to the substrate, the substrate becomes contaminated, and as a result, the yield in manufacturing of semiconductor devices is decreased.

Further, with the increasing integration of semiconductor devices, multilayer structures are required, and thus planarization is necessary after deposition of thin-film layers forming the multilayer structures. Accordingly, a substrate surface is planarized by chemical mechanical polishing (CMP: Chemical Mechanical Polishing). CMP is a method of planarizing the substrate surface with the chemical reaction of the abrasive solution and the mechanical action of sliding the substrate and grinding the surface with the abrasive grains.

When polishing the surface of the substrate also, foreign matters, such as polishing debris, may adhere to the substrate. Foreign matters adhering to semiconductor integrated circuits then cause shorts between wires and circuit defects.

Therefore, in order to improve a reliability of semiconductor integrated circuits and increase the yield, it is necessary to clean the substrate to remove foreign matters on the substrate. In conventional substrate cleaning methods for removing foreign matters from the substrate, cleaning of the substrate is typically performed by bringing a contact-type cleaning tool, such as a cleaning sponge, into contact with the substrate (see, for example, Patent Document 1).

### Citation List

### Patent Literature

Patent document 1: Japanese laid-open patent publication No. 2017-108113

### Summary of Invention

### Technical Problem

However, in the case of cleaning methods in which the cleaning tool is brought into contact with the substrate, according to a condition of the cleaning tool, there is a risk that foreign matters adhering to the substrate may not be removed sufficiently. For example, a cleaning tool that has been approaching an end of service life may not be able to efficiently remove foreign matters adhering to the surface of the substrate. Further, particles once removed by the cleaning tool during substrate cleaning may re-adhere to the substrate and contaminate the substrate, causing so-called reverse contamination to occur.

Therefore, the present invention provides a substrate processing apparatus and a substrate processing method capable of effectively cleaning a surface of a substrate without using a member that comes in contact with the substrate, such as a cleaning tool.

### Solution to Problem

In one embodiment, there is provided a substrate processing apparatus, comprising: a cleaning apparatus configured to clean a polished substrate, wherein the cleaning apparatus comprises: a cleaning holder configured to hold and rotate the substrate; and a microbubble-water module configured to inject microbubble water onto a surface of the substrate held by the cleaning holder to clean the surface of the substrate, and wherein the microbubble-water module comprises: at least one injection nozzle for injecting the microbubble water onto a target region which is an elongated region extending from at least a center of the substrate to outermost peripheral portion of the substrate; and a microbubble-water supply device for supplying the microbubble water to the injection nozzle.

In one embodiment, the substrate processing apparatus further comprises a polishing apparatus configured to polish the substrate, wherein the polishing apparatus comprises: a polishing holder configured to hold and rotate the substrate; a polishing head configured to press a polishing tool against the substrate to thereby polish the substrate; and a polishing-portion microbubble water module configured to inject, during polishing of the substrate, the microbubble water onto the surface of the substrate to thereby clean the surface of the substrate; and wherein the polishing-portion microbubble water module comprises: at least one polishing-portion injection nozzle configured to supply the microbubble water from the microbubble-water supply device; and the at least one polishing-portion injection nozzle is configured to inject the microbubble water onto the target region.

In one embodiment, the microbubble-water supply device further comprises a chemical-liquid injection device configured to add an alkaline chemical liquid to the microbubble water.

In one embodiment, the injection nozzle comprises a plurality of injection nozzles arranged along the target region and the plurality of injection nozzles are arranged such that parts of the injection range of the microbubble water from adjacent injection nozzles overlap with each other.

In one embodiment, the injection nozzle is configured as an elongated nozzle extending along the target region, and the elongated nozzle has one slit-shaped injection port for injecting the microbubble water toward the target region.

In one embodiment, the target region extends in a diameter direction passing through a center of the substrate, and over an entire length of the substrate.

In one embodiment, there is provided a substrate processing method, comprising: transferring a substrate to a cleaning apparatus; holding and rotating the substrate; and injecting microbubble water from an injection nozzle onto a target region, which is an elongated region extending from at least a center to an outermost peripheral portion of a surface of the rotating substrate, to clean the surface of the substrate.

In one embodiment, the substrate processing method further comprises: transferring the substrate to a polishing apparatus; holding and rotating the substrate; pressing a polishing tool against the rotating substrate by use of a polishing head to polish the substrate; and injecting microbubble water from a polishing-portion injection nozzle onto the target region to clean the surface of the substrate.

In one embodiment, cleaning the surface of the substrate is performed by use of microbubble water containing an alkaline chemical liquid.

In one embodiment, the injection nozzle comprises a plurality of injection nozzles arranged along the target region, and cleaning the surface of the substrate is performed by injecting the microbubble water such that parts of the injection range of the microbubble water from adjacent injection nozzles overlap with each other.

In one embodiment, the injection nozzle comprises an elongated nozzle extending along the target region, and cleaning the surface of the substrate is performed by injecting the microbubble water from one slit-shaped injection port formed in the elongated nozzle.

In one embodiment, the target region extends in a diameter direction passing through a center of the substrate, and over an entire length of the substrate.

### Advantageous Effects of Invention

According to the embodiments described above, the entire surface of the wafer W is cleaned by the microbubble water that can always maintain high cleaning ability. Therefore, the surface of the substrate can be effectively cleaned, and further, no reverse contamination occurs in which particles, temporarily removed by a cleaning tool during cleaning of the wafer W, re-adhere to the wafer W.

### Brief Description of Drawings

[FIG. 1] FIG. 1 is a plan view showing an overall configuration of a substrate processing apparatus according to one embodiment;
[FIG. 2A] FIG. 2A is a cross-sectional view of a so-called straight-type wafer;
[FIG. 2B] FIG. 2B is a cross-sectional view of a so-called round-type wafer;
[FIG. 3] FIG. 3 is a schematic view showing a cleaning module according to one embodiment;
[FIG. 4] FIG. 4 is a schematic view showing a microbubble-water supply device according to one embodiment;
[FIG. 5A] FIG. 5A is a schematic view showing an example of a relationship between a target region on the wafer and an injection range of microbubble water from the injection nozzle;
[FIG. 5B] FIG. 5B is a schematic view showing another example of the relationship between the target region on the wafer and the injection range of microbubble water from the injection nozzle;
[FIG. 5C] FIG. 5C is a schematic view showing still another example of the relationship between the target region on the wafer and the injection range of microbubble water from the injection nozzle;
[FIG. 6A] FIG. 6A is a side view showing the injection nozzle according to another embodiment,
[FIG. 6B] FIG. 6B is a schematic bottom view of the injection nozzle shown in FIG. 6A; [FIG. 7] FIG. 7 is a schematic view showing a polishing unit according to one embodiment; and
[FIG. 8] FIG. 8 is a view showing a manner in which the polishing head polishes the peripheral portion (bevel portion) of the wafer.

### Description of Embodiments

Embodiments according to the present invention will be described below with reference to the drawings.

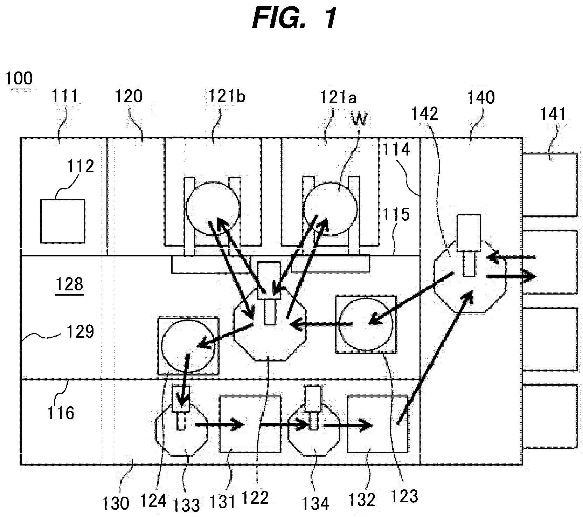

FIG. 1 is a plan view showing an overall configuration of a substrate processing apparatus according to one embodiment. The arrows in FIG. 1 indicate transfer directions of a wafer W, which is an example of a substrate. The substrate processing apparatus 100 shown in FIG. 1 includes a first polishing module (first polishing apparatus) 121a and a second polishing module (second polishing apparatus) 121b that polish the peripheral portion of a wafer W, respectively, a cleaning module (cleaning apparatus) 131 that cleans the wafer W polished by the first polishing module 121a or the second polishing module 121b, and a drying module 132 that dries the cleaned wafer W.

In the following, embodiments in which the substrate processing apparatus 100 includes two polishing apparatuses configured to polish the peripheral portion of the wafer W (hereinafter referred to as "bevel polishing apparatuses") will be described. However, the type and the number of polishing apparatuses provided in the substrate processing apparatus 100 are not limited to this example. For example, the substrate processing apparatus 100 may include one polishing apparatus or three or more polishing apparatuses. Moreover, the substrate processing apparatus 100 may include at least one CMP apparatus for polishing a surface of the wafer (substrate) W, or may include at least one bevel polishing apparatus and at least one notch polishing apparatus configured to polish a notch formed on the peripheral portion of the wafer W.

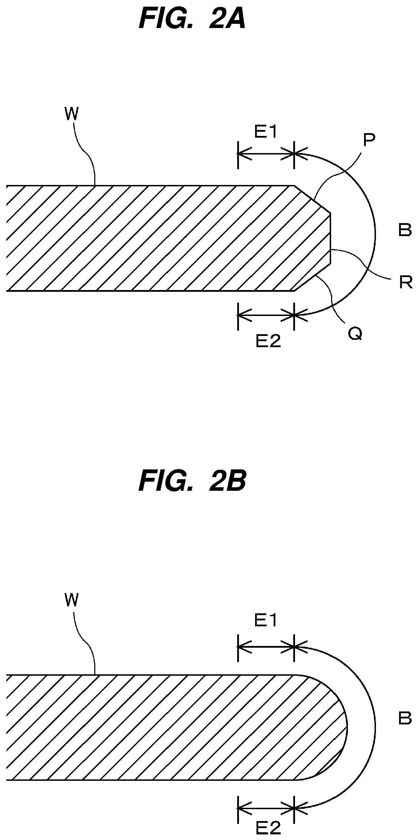

FIG. 2A and FIG. 2B are enlarged cross-sectional views each showing a peripheral portion of a wafer. More specifically, FIG. 2A is a cross-sectional view of a so-called straight-type wafer, and FIG. 2B is a cross-sectional view of a so-called round-type wafer. In the wafer W shown in FIG. 2A, a bevel portion is an outermost circumferential surface of the wafer W (indicated by a letter B) that is constituted by an upper slope portion (an upper bevel portion) P, a lower slope portion (a lower bevel portion) Q, and a side portion (an apex) R.

In the wafer W shown in FIG. 2B, the bevel portion is a portion (indicated by a letter B) having a curved cross section and forming an outermost circumferential surface of the wafer W. A top edge portion E1 is a flat portion located radially inwardly of the bevel portion B and located radially outwardly of a region D where devices are formed. The top edge portion E1 may include the region where the device is formed. A bottom edge portion E2 is a flat portion located radially inwardly of the bevel portion B and located at an opposite side from the top edge portion E1. The top edge portion E1 and the bottom edge portion E2 may be collectively referred to as a near edge portion.

Returning to FIG. 1, the substrate processing apparatus 100 has a substantially rectangular housing. An interior of the housing is partitioned into a polishing unit 120, a cleaning unit 130, and a load/unload unit 140 by partition walls 114, 115, 116. The polishing unit 120, the cleaning unit 130, and the load/unload unit 140 are independently assembled and independently evacuated. Further, the substrate processing apparatus 100 is provided with a controller 111 for controlling operations of the polishing unit 120, the cleaning unit 130, and the load/unload unit 140.

As shown in FIG. 1, the load/unload unit 140 has a plurality (four in the illustrated example) of front load portions 141 arranged adjacent to each other in a front side of the load/unload unit 140, and a first transfer robot 142 movable in an arrangement direction of the front load portions 141.

Wafer cassette for storing the plurality of wafers W is placed on the front load portion 141. Specifically, the front load portion 141 may be placed with, for example, an open cassette, an SMIF (Standard Manufacturing Interface) pod, or a FOUP (Front Opening Unified Pod). SMIF and FOUP are closed containers that accommodate wafer cassettes and are covered with partition walls to maintain an environment independent of the external space.

The first transfer robot 142 moves along the arrangement direction of the front load portions 141, and is thus capable of accessing the wafer cassettes loaded on each front load portion 141. This first transfer robot 142 has two hands (not shown) located above and below, and is, for example, configured to use the upper hand when returning the wafer W to the wafer cassette and to use the lower hand when transferring the wafer W before polishing, so that the upper and lower hands can be used separately.

The polishing unit 120 shown in FIG. 1 corresponds to an area where polishing of the wafer W is performed, and includes at least one (two in the illustrated example) polishing modules 121a and 121b, a first temporary table 123 where the wafer W before polishing is temporarily placed, a second temporary table 124 where the wafer W after polishing is temporarily placed, and a second transfer robot 122 for transferring the wafer W between the polishing modules 121a, 121b, the first temporary table 123, and the second temporary table 124. In the present embodiment, the polishing modules 121a and 121b are bevel polishing apparatus, respectively, which polishes the peripheral portion of the substrate by sliding a polishing tool in contact with the peripheral portion of the substrate in a presence of a liquid, such as pure water and a chemical liquid.

The cleaning unit 130 corresponds to an area for cleaning and further drying the wafer W after polishing, and includes a cleaning module 131, a drying module 132, a third transfer robot 133, and a fourth transfer robot 134. In the embodiment shown in FIG. 1, the substrate processing apparatus 100 includes one cleaning module 131 and one drying module 132. However, the number of cleaning modules 131 and the number of drying modules 132 are freely selected.

The third transfer robot 133 is disposed between the second temporary table 124 of the polishing unit 120 and the cleaning module 131, and transfers the wafer W after polishing from the second temporary table 124 to the cleaning module 131. The fourth transfer robot 134 is disposed between the cleaning module 131 and the drying module 132, and transfers the wafer W after cleaning from the cleaning module 131 to the drying module 132. The cleaning module 131 is an apparatus for cleaning the wafer W after polishing, and details of its configuration will be described later.

Drying module 132 is an apparatus for drying the wafer W after cleaning, and any known drying module can be used as long as the drying module can dry the wafer W. As an example of such drying module 132, a spin-dry type drying module may be used, which has a stage capable of high-speed rotation of the wafer W chucked thereon, and dries the wafer W after cleaning by rotating the wafer W at high speed.

As shown in FIG. 1, the partition wall 114 serves as a partition wall that partitions the polishing unit 120 and the cleaning unit 130 from the load/unload unit 140. A transfer area 128, in which the second transfer robot 122 is disposed, is formed between the partition wall 115 that partitions the polishing unit 120 and the partition wall 116 that partitions the cleaning unit 130. The wafer W, which has been polished by the polishing modules 121a and 121b of the polishing unit 120, is transferred through the transfer area 128 to the cleaning module 131 of the cleaning unit 130.

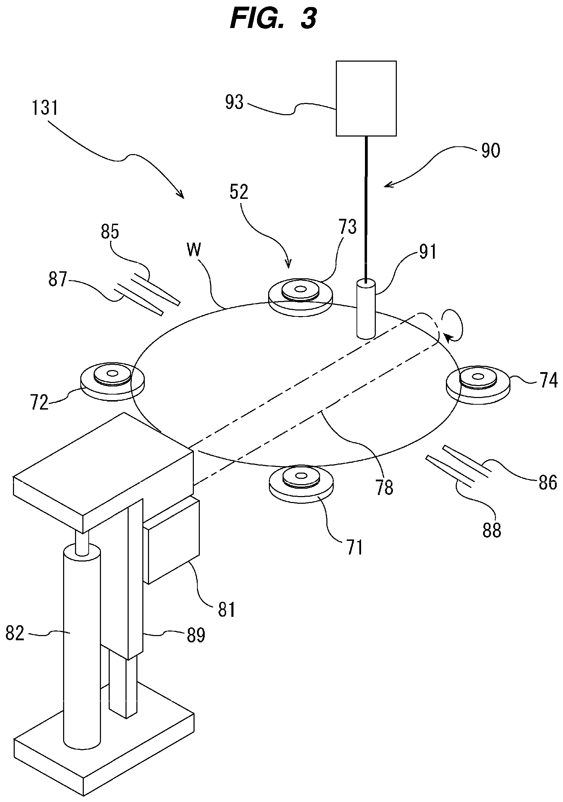

FIG. 3 is a schematic view showing a cleaning module (cleaning apparatus) according to one embodiment. As shown in FIG. 3, the substrate cleaning apparatus includes a cleaning holder (substrate holder) 52 having four holding rollers 71, 72, 73, 74 for holding the peripheral portion of the wafer W and rotating the wafer W about its central axis, a cylindrical roll sponge (roll cleaning tool) 78 configured to come into contact with a lower surface of the wafer W, a rotational mechanism 81 configured to rotate the roll sponge 78 about its central axis, lower pure-water supply nozzles 85, 86 configured to supply pure water to the lower surface of the wafer W, and lower chemical-liquid supply nozzles 87, 88 configured to supply a chemical liquid to the lower surface of the wafer W. The chemical liquid and the pure water in the present embodiment are examples of lower cleaning liquid for cleaning the lower surface of the wafer W, respectively, and the lower chemical-liquid supply nozzles 87, 88 and the lower pure-water supply nozzles 85, 86 constitute lower cleaning-liquid supply nozzles for supplying cleaning liquid to the lower surface of the wafer W.

In this specification, an "upper surface" of the substrate (the wafer W) refers to a front surface of the substrate on which patterns are formed, and a "lower surface" of the substrate refers to a back surface of the substrate on which no patterns are formed. In the embodiment shown in FIG. 3, the lower surface of the wafer W is cleaned by pressing the roll sponge 78 against the lower surface of the wafer W, which is the back surface of the wafer W, in the presence of a cleaning liquid.

The central axis of the roll sponge 78 extends parallel to the surface of the wafer W held by the holding rollers 71, 72, 73, 74. The holding rollers 71, 72, 73, 74 are movable in directions to approach to and separate from the wafer W by a drive mechanism (e.g., an air cylinder), which is not shown. Further, at least two of the holding rollers 71, 72, 73, 74 are coupled to a roller rotating mechanism, which is not shown.

Only one end of the roll sponge 78 may be supported in a cantilevered manner by the rotating mechanism 81, or both ends of the roll sponge 78 may be supported by using a roll arm (not shown). The roll arm includes, for example, an arm portion extending from the rotary mechanism 81 along a longitudinal direction of the roll sponge 78, and a support portion extending vertically from the arm portion. One end of the roll sponge 78 is supported by the rotary mechanism 81, and the other end of the roll sponge 78 is rotatably supported by the support portion.

The rotary mechanism 81 for rotating the roll sponge 78 configured to clean the lower surface of the wafer W is mounted to a guide rail 89 for guiding vertical movement thereof. Further, the rotary mechanism 81 is supported by a load generating mechanism 82, and the rotary mechanism 81 and the roll sponge 78 are configured to be moved vertically by the load generating mechanism 82. Examples of the load generating mechanism 82 may include a motor drive mechanism using a ball screw, or an air cylinder. The rotary mechanism 81 and the load generating mechanism 82 are coupled to the above-mentioned controller 111 (see FIG. 1), and operations of the rotary mechanism and the load generating mechanism are controlled by the controller 111.

As shown in FIG. 3, the cleaning unit 131 includes a microbubble-water module 90 for cleaning the upper surface of the wafer W. The microbubble-water module 90 includes an injection nozzle 91 for injecting microbubble water onto the surface of the substrate, and a microbubble-water supply device 93 for supplying microbubble water to the injection nozzle 91. The microbubble water serves as cleaning water for removing foreign matters (particles), such as polishing debris, adhering to the surface of the substrate.

The microbubble water is also referred to as fine-bubble water. The microbubble water is water containing extremely fine bubbles (e.g., bubbles having a diameter of 100µm or less), and has high cleaning ability. The microbubble-water supply device 93 supplies the microbubble water to the injection nozzle 91, and then the injection nozzle 91 injects the microbubble water onto a target region in the surface of the substrate. In other words, an injection range of microbubble water from the injection nozzle 91 is preset so as to correspond to the target region in the wafer W.

As a result of extensive research by the inventors into the cleaning (removal of foreign matters) of a substrate surface with microbubble water, it has been found that microbubble water immediately after generation, in other words, immediately after being injected from the injection nozzle 91, has a high cleaning ability. On the other hand, it has also been found that the cleaning ability decreases as time passes after the generation of microbubble water. Therefore, in the present embodiment, the microbubble-water module 90 of the cleaning unit 131 is configured in such a way that the microbubble water is injected from the injection nozzle 91 onto the wafer W immediately after the generation of the microbubble water.

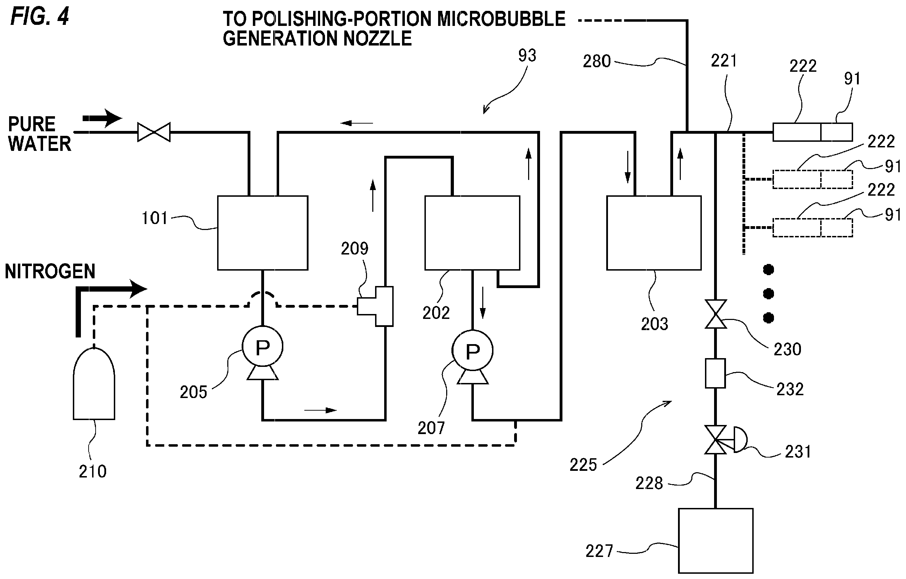

FIG. 4 is a schematic view showing a microbubble-water supply device according to one embodiment. The microbubble-water supply device 93 shown in FIG. 4 includes a first generation tank 201, a second generation tank 202, a third generation tank 203, a levitation pump 205, a bellows pump 207, an ejector 209, a gas supply source 210, and a microbubble-water generation nozzle 222, and a supply line 221 extending from the third generation tank 203 to the microbubble-water generation nozzle 222. The microbubble-water supply device is not limited to the example shown in FIG. 4, as long as the microbubble-water supply device can generate microbubble water and supply microbubble water to the injection nozzle 91. Any known microbubble-water supply device may be used as the microbubble-water supply device in the present embodiment.

The gas-supply source 210 is provided to supply gas, which is used to generate bubbles contained in the microbubble water, to the pure water. Examples of gas supplied from the gas-supply source 210 may include an inert gas (e.g., nitrogen), oxygen, and ozone. In the following, an example will be described in which the gas supplied from gas-supply source 210 is nitrogen.

The microbubble water is generated as follows. Pure water is supplied to the first generation tank 201 from a pure-water supply source, which is not shown in the drawings. The pure water in the first generation tank 201 is sent to the ejector 209 by the levitation pump 205. Nitrogen is supplied from the gas supply source 210 to the ejector 209, and the nitrogen is mixed with the pure water. A mixture fluid of pure water and nitrogen is sent from the ejector 209 to the second generation tank 202, and nitrogen-containing water is generated in the second generation tank 202. A part of the generated nitrogen-containing water is returned to the first generation tank 201, and circulates between the first generation tank 201 and the second generation tank 202. With this operation, nitrogen-containing water with a high concentration can be generated.

The nitrogen-containing water is sent from the second generation tank 202 to the third generation tank 203 by the bellows pump 207. The gas supplied from the gas supply source 210 is also introduced into and mixed with the nitrogen-containing water flowing from the second generation tank 202 to the third generation tank 203. Dissolving further nitrogen into the nitrogen-containing water flowing toward the third generation tank 203 enables a nitrogen concentration of the nitrogen-containing water stored in the third generation tank 203 to be increased. Thereafter, the nitrogen-containing water in the third generation tank 203 is supplied to the microbubble-water generation nozzle 222 through the supply line (nitrogen-containing water supply line) 221. In the microbubble-water generation nozzle 222, the nitrogen contained in the nitrogen-containing water is converted into microbubbles, thereby generating microbubble-water containing fine nitrogen bubbles.

In the present embodiment, the injection nozzle 91 is directly connected to the microbubble-water generation nozzle 222. With such configuration, the microbubble-water immediately after generation can be injected from the injection nozzle 91 onto the surface of the wafer W. As a result, the microbubble-water having extremely high cleaning ability (or foreign-matters removal ability) can be injected onto the surface of the wafer W.

Increasing a discharge pressure of microbubble water from a microbubble-water generation nozzle 222 enables the microbubble water containing a large number of microbubbles to be injected toward the surface of the wafer W from the injection nozzle 91. As an example, the above-mentioned discharge pressure is set to 0.2 MPa or more.

In one embodiment, a discharge diameter of the microbubble-water generation nozzle 222 and a discharge diameter of the injection nozzle 91 may be smaller than a diameter of the supply line 221. In one embodiment, the discharge diameter of the injection nozzle 91 may be smaller than the discharge diameter of the microbubble-water generation nozzle 222. With such configurations, the above-mentioned discharge pressure can be further increased, resulting in performing a more stable cleaning effect (foreign-matters removal effect).

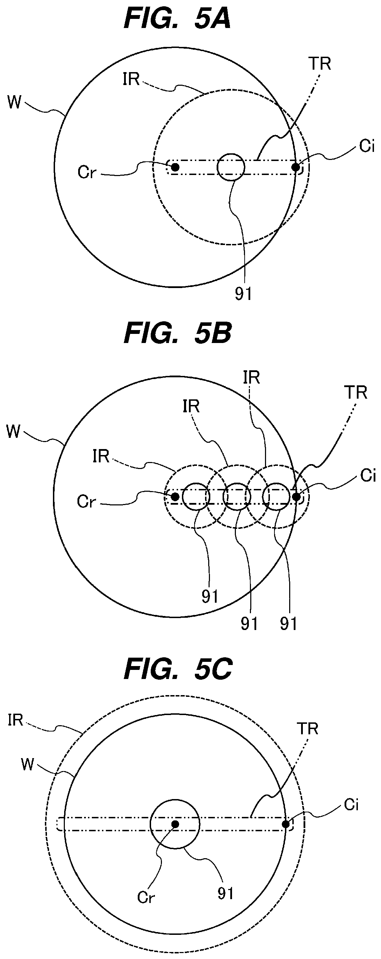

FIG. 5A is a schematic view showing an example of a relationship between a target region on the wafer W and an injection range of microbubble water from the injection nozzle, FIG. 5B is a schematic view showing another example of the relationship between the target region on the wafer W and the injection range of microbubble water from the injection nozzle, and FIG. 5C is a schematic view showing still another example of the relationship between the target region on the wafer W and the injection range of microbubble water from the injection nozzle.

The target regions TR shown in FIG. 5A and FIG. 5B are elongated areas which are set so as to extend in a straight line in a diameter direction of the wafer W from a center Cr of the wafer W, held by the substrate holder 52, to an outermost peripheral portion Ci, respectively. In the example shown in FIG. 5A, the microbubble water is injected toward the target region TR by one injection nozzle 91. On the other hand, in the example shown in FIG. 5B, the microbubble water is injected toward the target region TR by a plurality of (three in the illustrated example) injection nozzles 91. In this case, arrangement of the injection nozzles 91 and/or injection ranges of the microbubble water are adjusted such that parts of injection range IR of microbubble water from adjacent injection nozzles 91 overlap with each other. Further, it is preferred that the plurality of injection nozzles 91 simultaneously inject the microbubble water toward the wafer W. In this manner, the number of and the arrangement of the injection nozzles 91 and the injection ranges IR of the microbubble water in the microbubble water module 90 can be freely selected or set, as long as the microbubble water injected from the injection nozzle(s) 91 is injected over the target region TR in its entirety.

In the example shown in FIG. 5C, the target region TR extends in the diameter direction passing through the center Cr of the wafer W and over an entire length of the wafer W, and the microbubble water is injected from one injection nozzle 91 onto this target region TR. Although not shown, the microbubble water may be injected from a plurality of injection nozzles 91 into the target region TR extending over the entire length of the wafer W shown in FIG. 5C. In this case, the number of and the arrangement of the injection nozzles 91 and/or the injection ranges IR of the microbubble water are adjusted such that parts of the injection range IR of the microbubble water from adjacent injection nozzles 91 overlap with each other. Further, it is preferred that the plural injection nozzles 91 simultaneously inject the microbubble water toward the wafer W.

According to the configuration shown in FIG. 5C, during cleaning of the wafer W, the entire surface of the wafer W always comes into contact with the microbubble water immediately after being injected from the injection nozzle 91. As a result, cleaning of the wafer W can be completed in a short time, and thus throughput of the cleaning module 131 can be increased.

The microbubble water is injected from the injection nozzle 91 onto the target region TR of the wafer W while the wafer W is rotated by the substrate holder 52, thereby bringing the entire surface of the wafer W into contact with the microbubble water immediately after being injected from the injection nozzle 91. In other words, since the microbubble water having high cleaning ability is injected onto the target region TR while the wafer W is rotated by the substrate holder 52, the entire surface of the wafer W can be effectively cleaned.

Further, cleaning of the surface of the wafer W by use of the microbubble water is different from the contact-type cleaning method using a cleaning tool, such as a roll sponge, in that the cleaning ability of the wafer W does not change (decrease) depending on a condition of the cleaning tool. In other words, cleaning of the surface of the wafer W by use of the microbubble water can always maintain high cleaning ability. Moreover, no reverse contamination occurs, in which particles temporarily removed by the cleaning tool during cleaning of the wafer W re-adhere to the wafer W. In addition, since only the microbubble water comes into contact with the surface of the wafer W, it is possible to prevent, to the greatest extent possible, defects, such as damage to devices formed on the surface of the wafer W.

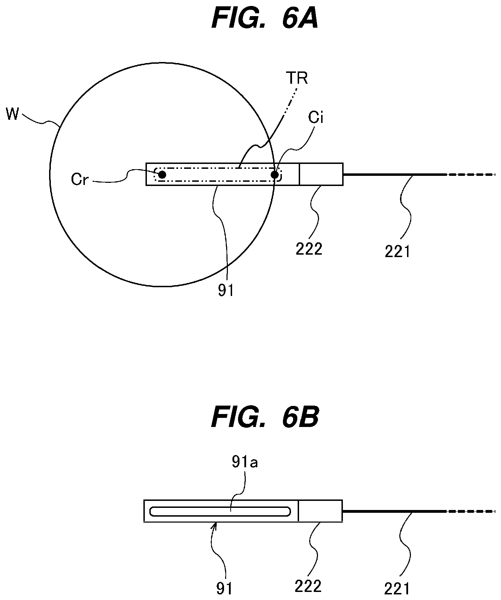

FIG. 6A is a side view showing the injection nozzle according to another embodiment, and FIG. 6B is a schematic bottom view of the injection nozzle shown in FIG. 6A. The injection nozzle 91 shown in FIG. 6A is configured as an elongated nozzle extending along the target region TR (see FIGS. 5A and 5B). As shown in FIG. 6B, a single slit 91a extending along a longitudinal direction of the injection nozzle 91 is formed in a bottom surface thereof, and the microbubble water is injected from the slit 91a toward the target region of the wafer W. Even with such a configuration, the microbubble water immediately after being injected from the slit 91a of the injection nozzle 91 can be brought into contact with the entire surface of the rotating wafer W, thereby enabling effective cleaning of the entire surface of the wafer W.

Although not shown, a plurality of injection ports which are arranged along the longitudinal direction of the injection nozzle 91 may be formed in the bottom surface of the injection nozzle 91, shaped as the elongated nozzle as shown in FIG. 6A. In this case, the number of and the arrangement of the injection ports and/or the injection ranges of the microbubble water are adjusted such that parts of the injection range of the microbubble water from adjacent injection ports overlap with each other.

It is also possible to inject the microbubble water onto the target region TR extending along the entire length of the wafer W shown in FIG. 5C by use of the injection nozzle 91 shaped like the elongated nozzle shown in FIG. 6A and FIG. 6B. In this case, the injection nozzle 91 extends along the target region TR, and has a length that is approximately equal to or slightly greater than the diameter of the wafer W. With such a configuration, the surface of the wafer W comes into contact with the microbubble water immediately after being injected from the injection nozzle 91 twice during one rotation of the wafer W. As a result, cleaning of the wafer W can be completed in a short time, and thus the throughput of the cleaning module 131 can be increased.

As shown in FIG. 4, the microbubble-water supply device 93 may be provided with a chemical-liquid supply device 225 for adding an alkaline chemical liquid to the microbubble water. The chemical-liquid supply device includes a chemical-liquid supply source 227, and a chemical-liquid supply line 228 which extends from the chemical-liquid supply source 227 and is coupled to the supply line 221. In the chemical-liquid supply line 228 shown in FIG. 4, an opening/closing valve 230, a pressure regulator 231, such as a pressure reducing valve, and a flow rate regulator 232, such as a mass flow controller, are disposed. The opening/closing valve 230 and the flow rate regulator 232 are coupled to the controller 111 (see FIG. 1), and the controller 111 is configured to adjust timing for adding alkaline liquid to the microbubble water and a flow rate of the added alkaline liquid. In one embodiment, any one or two of the opening/closing valve 230, the pressure regulator 231, and the flow rate regulator 232 may be omitted. Furthermore, the flow rate regulator 232 may be a flow rate control valve, such as a needle valve.

When an alkaline chemical liquid is added to the nitrogen-containing water, the microbubble water injected from the injection nozzle 91 contains the alkaline chemical liquid. The alkaline chemical liquid improves the cleaning ability on the wafer W, further increasing the cleaning ability of the microbubble water injected from the injection nozzle 91. Examples of such alkaline chemical liquid may include ammonia, and tetramethylammonium hydroxide (TMAH).

Although not shown, while the surface of the wafer W is being cleaned using the microbubble water, an alkaline chemical liquid may be supplied onto the surface of the wafer W to add the alkaline chemical liquid to the microbubble water present on the surface of the wafer W. In this case, unlike the example shown in FIG. 4, an end of the chemical-liquid supply line 228 is not coupled to the supply line 221. A chemical-liquid supply nozzle for supplying the alkaline chemical liquid to the surface of the wafer W is coupled to the end of the chemical-liquid supply line 228.

Next, the polishing unit (polishing apparatus) 121a will be described below. In the present embodiment, the polishing unit 121b has the same configuration as the polishing unit 121a, and thus, duplicate descriptions thereof are omitted.

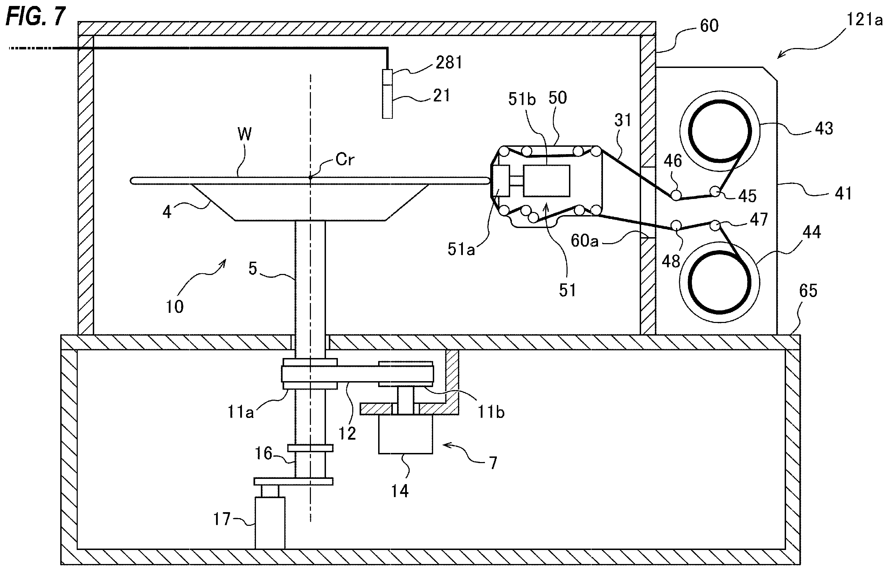

FIG. 7 is a schematic view showing a polishing unit according to one embodiment. As described above, the polishing unit 121a shown in FIG. 7 is a bevel polishing apparatus for polishing the peripheral portion (see FIGS. 2A and 2B) of the wafer W. As shown in FIG. 7, the polishing unit 121a includes a substrate holder 10 for holding and rotating the wafer W, a polishing head 50 for polishing the peripheral portion of the wafer W by bringing a polishing tool into contact with the peripheral portion of the wafer W held by the substrate holder 10, and at least one (one in the illustrated example) polishing-portion injection nozzle 21 for supplying the microbubble water onto the wafer W.

The polishing-portion injection nozzle 21 is coupled to a branch line 280 (see FIG. 4), which branches from the supply line 221 of the microbubble-water supply device 93 described above, through a polishing-portion microbubble generation nozzle 281. In the example shown in FIG. 7, the polishing-portion microbubble generation nozzle 281 is directly connected to the polishing-portion injection nozzle 21. Therefore, the polishing-portion injection nozzle 21 can inject the microbubble water immediately after generating the microbubbles onto the wafer W. In the present embodiment, the polishing-portion microbubble water module is constituted by the polishing-portion injection nozzle 21, the polishing-portion microbubble generation nozzle 281, and the branch line 280 branching from the supply line 221 of the microbubble water supply device 93.

FIG. 7 illustrates a state in which the substrate holder 10 holds the wafer W. The substrate holder 10 includes a holding stage 4 configured to hold the wafer W by use of vacuum suction, a shaft 5 coupled to a central portion of the holding stage 4, and a holding-stage drive mechanism 7 configured to rotate the holding stage 4 and move the holding stage 4 up and down. The holding-stage drive mechanism 7 is configured to rotate the holding stage 4 about a central axis thereof and to move the holding stage 4 up and down along the central axis.

The holding stage 4, the polishing head 50, and the holding stage 4 are disposed within the partition wall 60. An interior space of the partition wall 60 provides a polishing room in which the wafer W is polished. The partition wall 60 is disposed on a base plate 65. The shaft 5 extends through the base plate 65.

The holding-stage drive mechanism 7 includes a motor 14 as a stage rotation device for rotating the holding stage 4, and an air cylinder 17 for moving the holding stage 4 up and down. The motor 14 is fixed to a lower surface of the base plate 65. The holding stage 4 is rotated by the motor 14 via the shaft 5, a pulley 11a coupled to the shaft 5, a pulley 11b mounted on a rotary shaft of the motor 14, and a belt 12 riding on the pulleys 11a and 11b. The rotary shaft of motor 14 extends parallel to the shaft 5. With these structures, the wafer W, held on an upper surface of the holding stage 4, is rotated by the motor 14. The shaft 5 is coupled to the air cylinder 17 via a rotary joint 16 mounted to a lower end of the shaft 5, and the shaft 5 and the holding stage 4 can be moved up and down by the air cylinder 17.

The wafer W is placed on the upper surface of the holding stage 4 such that the center Cr of the wafer W is aligned with the central axis of the holding stage 4. The wafer W is held on the upper surface of the holding stage 4 with the device surface facing upward. With such a configuration, the substrate holder 10 can rotate the wafer W about the central axis of the holding stage 4, and move the wafer W up and down along the central axis of the holding stage 4.

In the present embodiment, a polishing tape 31 having abrasive grains on a surface thereof is used as an example of the polishing tool. The polishing apparatus 1 further includes a polishing-tool supply/recovery mechanism 41 for supplying the polishing tape 31 to the polishing head 50 and recovering the polishing tape 31 from the polishing head 50. The polishing-tool supply/recovery mechanism 41 is disposed outside the partition wall 60. The polishing-tool supply/recovery mechanism 41 includes a supply reel 43 for supplying the polishing tape 31 to the polishing head 50, and a recovery reel 44 for recovering the polishing tape 31 used for polishing the wafer W. Tension motors, which are not shown, are coupled to the supply reel 43 and the recovery reel 44, respectively. Each tension motor is configured to apply a predetermined torque to the supply reel 43 and the recovery reel 44, thereby applying a predetermined tension to the polishing tape 31.

The polishing tape 31 is supplied to the polishing head 50 such that a polishing surface of the polishing tape 31 faces toward a surface to be polished, of the peripheral portion of the wafer W. The polishing tape 31 is supplied from the supply reel 43 to the polishing head 50 through an opening 60a provided in the partition wall 60, and the used polishing tape 31 is recovered to the recovery reel 44 through the opening 60a. The polishing-tool supply/recovery mechanism 41 further includes a plurality of guide rollers 45, 46, 47, and 48 for supporting the polishing tape 31. A direction of travel of the polishing tape 31 is guided by the guide rollers 45, 46, 47, and 48.

As shown in FIG. 7, the polishing head 50 is provided with a pressing mechanism 51 for pressing the polishing tape 31 against the peripheral portion of the wafer W. The polishing tape 31 is supplied such that the polishing tape 31 passes through an end surface of the pressing mechanism 51. In the present embodiment, the pressing mechanism 51 includes a pressing pad 51a for supporting a back surface of the polishing tape 31, and an air cylinder 51b coupled to the pressing pad 51a. The polishing head 50 presses the polishing tape 31 from a back side thereof by the pressing mechanism 51, and polishes the peripheral portion of the wafer W by bringing the polishing surface of the polishing tape 31 into contact with the peripheral portion of the wafer W.

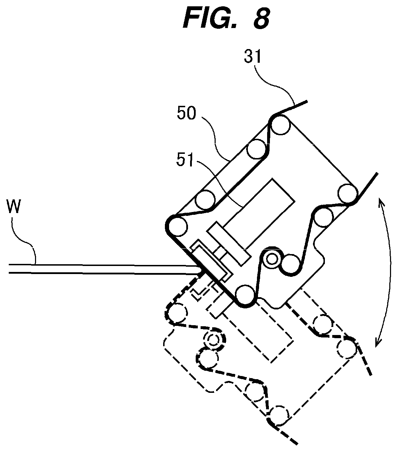

FIG. 8 is a view showing a manner in which the polishing head polishes the peripheral portion (bevel portion) of the wafer. When polishing the peripheral portion of the wafer W, as shown in FIG. 8, the polishing tape 31 is pressed against the peripheral portion (e.g., bevel portion) of the water W by use of the pressing mechanism 51 while an inclination angle of the polishing head 50 is changed continuously by a tilting mechanism which is not shown. During polishing of the wafer W, the polishing tape 31 may be fed at a predetermined speed by the tape feed mechanisms. In this manner, changing the angle of the polishing head 50 along the peripheral portion of the wafer W enables the entire peripheral portion of the wafer W to be polished. In one embodiment, a grinding stone may be used as the polishing tool, instead of the polishing tape 31.

During polishing of the wafer W, the microbubble water is injected from the polishing-portion injection nozzle 21 onto the target region in the surface of the wafer W. In the present embodiment also, the target region is the same as the target region TR illustrated with reference to FIGS. 5 and 6. Further, as illustrated with reference to FIGS. 5 and 6, the polishing-portion injection nozzle 21 may comprise a plurality of polishing-portion injection nozzles 21 arranged along the target region TR, or may be configured as the elongated nozzle.

As shown in FIG. 4, the branch line 280 branches from an upstream side of the chemical-liquid supply line 228 in the supply line 221 of the microbubble-water supply device 93. Therefore, no alkaline chemical liquid is added to the microbubble water supplied to the polishing unit 121a. Of course, the branch line 280 may branch from a downstream side of the chemical-liquid supply line 228 in the supply line 221 of the microbubble-water supply device 93, so that alkaline chemical liquid can be added to the microbubble water supplied to the polishing unit 121a.

During polishing of the wafer W, while the wafer W is rotated with being held on the holding stage 4, the microbubble water is injected from the polishing-portion injection nozzle 21 toward the target region of the wafer W, and further the polishing tape 31 (polishing tool) is pressed against the peripheral portion of the wafer W by use of the polishing head 50. With these operations, the peripheral portion of the wafer W can be polished while the microbubble water is injected onto the entire surface of the wafer W. The microbubble water forms a water film on the surface of the wafer W, and thus the water film effectively prevents foreign matters, such as polishing debris, from adhering to the surface of the wafer W. Further, even if some foreign matters breaking through the water film formed by the microbubble water, adhere to the surface of the wafer W, those foreign matters are rinsed away by the microbubble water having high cleaning ability, so that contamination of the surface of the wafer W due to foreign matters during polishing is effectively prevented. Therefore, it is possible to reduce a load on the cleaning process of the wafer W in the cleaning unit 131 described above, and to improve the throughput of the wafer W.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention relates to a substrate processing apparatus and a substrate processing method for cleaning a substrate (e.g., a semiconductor wafer) after polishing, and in particular, is applicable to a substrate processing apparatus and a substrate processing method for cleaning a surface of the substrate after polishing a peripheral portion of the substrate.

### Reference Signs List

- 52: cleaning holder (substrate holder)
- 90: microbubble-water module
- 91: injection nozzle
- 93: microbubble-water supply device
- 100: substrate processing apparatus
- 121a, 121b: polishing module (polishing apparatus)
- 131: cleaning module (cleaning apparatus)
- 132: drying module
- 201: first generation tank
- 202: second generation tank
- 203: third generation tank
- 205: levitation pump
- 207: bellows pump
- 209: ejector
- 210: gas supply source
- 221: supply line
- 222,281: microbubble generation nozzle
- 225: chemical-liquid supply device

## Claims

1. A substrate processing apparatus, comprising:
a cleaning apparatus configured to clean a polished substrate,
wherein the cleaning apparatus comprises:
a cleaning holder configured to hold and rotate the substrate; and
a microbubble-water module configured to inject microbubble water onto a surface of the substrate held by the cleaning holder to clean the surface of the substrate, and
wherein the microbubble-water module comprises:
at least one injection nozzle for injecting the microbubble water onto a target region which is an elongated region extending from at least a center of the substrate to outermost peripheral portion of the substrate; and
a microbubble-water supply device for supplying the microbubble water to the injection nozzle.

2. The substrate processing apparatus according to claim1, further comprising a polishing apparatus configured to polish the substrate,
wherein the polishing apparatus comprises:
a polishing holder configured to hold and rotate the substrate;
a polishing head configured to press a polishing tool against the substrate to thereby polish the substrate; and
a polishing-portion microbubble water module configured to inject, during polishing of the substrate, the microbubble water onto the surface of the substrate to thereby clean the surface of the substrate; and
wherein the polishing-portion microbubble water module comprises:
at least one polishing-portion injection nozzle configured to supply the microbubble water from the microbubble-water supply device; and
the at least one polishing-portion injection nozzle is configured to inject the microbubble water onto the target region.

3. The substrate processing apparatus according to claim1, wherein the microbubble-water supply device further comprises a chemical-liquid injection device configured to add an alkaline chemical liquid to the microbubble water.

4. The substrate processing apparatus according to claim1, wherein the injection nozzle comprises a plurality of injection nozzles arranged along the target region and
the plurality of injection nozzles are arranged such that parts of the injection range of the microbubble water from adjacent injection nozzles overlap with each other.

5. The substrate processing apparatus according to claim1, wherein the injection nozzle is configured as an elongated nozzle extending along the target region, and
the elongated nozzle has one slit-shaped injection port for injecting the microbubble water toward the target region.

6. The substrate processing apparatus according to claim1, wherein the target region extends in a diameter direction passing through a center of the substrate, and over an entire length of the substrate.

7. A substrate processing method, comprising:
transferring a substrate to a cleaning apparatus;
holding and rotating the substrate; and
injecting microbubble water from an injection nozzle onto a target region, which is an elongated region extending from at least a center to an outermost peripheral portion of a surface of the rotating substrate, to clean the surface of the substrate.

8. The substrate processing method according to claim 7, further comprising:
transferring the substrate to a polishing apparatus;
holding and rotating the substrate;
pressing a polishing tool against the rotating substrate by use of a polishing head to polish the substrate; and
injecting microbubble water from a polishing-portion injection nozzle onto the target region to clean the surface of the substrate.

9. The substrate processing method according to claim 7, wherein cleaning the surface of the substrate is performed by use of microbubble water containing an alkaline chemical liquid.

10. The substrate processing method according to claim 7, wherein the injection nozzle comprises a plurality of injection nozzles arranged along the target region, and
cleaning the surface of the substrate is performed by injecting the microbubble water such that parts of the injection range of the microbubble water from adjacent injection nozzles overlap with each other.

11. The substrate processing method according to claim 7, wherein the injection nozzle comprises an elongated nozzle extending along the target region, and
cleaning the surface of the substrate is performed by injecting the microbubble water from one slit-shaped injection port formed in the elongated nozzle.

12. The substrate processing method according to claim 7, wherein the target region extends in a diameter direction passing through a center of the substrate, and over an entire length of the substrate.
